# EUROPEAN PATENT SPECIFICATION

(11) **EP 1 546 275 B1**
(45) Date of publication and mention of the grant of the patent: **28.02.2007**
(21) Application number: 03797583.6
(22) Date of filing: 12.09.2003
(51) Int. Cl.: C09J 5/00, C09J 9/02, C09J 157/00, C09J 163/10, B32B 15/08, B05D 1/04, B05D 7/24

(54) **METHOD OF ADHESION OF CONDUCTIVE MATERIALS, LAMINATE, AND ADHESIVE COMPOSITION**
VERFAHREN ZUM VERKLEBEN VON LEITFÜHIGEN MATERIALIEN, LAMINAT UND KLEBSTOFF
PROCEDE D'ADHESION DE MATERIAUX CONDUCTEURS, STRATIFIES ET COMPOSITION ADHESIVE

(30) Priority: 18.09.2002 JP 2002272100
(43) Date of publication of application: 29.06.2005
(73) Proprietor: Nippon Paint Co., Ltd., Osaka-shi, Osaka 531-8511 (JP)
(72) Inventor: SAKAMOTO, Hiroyuki, Kobe-shi, Hyogo 658-0032 (JP); KUROSAKI, Yoshinobu, Kobe-shi, Hyogo 658-0052 (JP); KAWANAMI, Toshitaka, Kawabe-gun, Hyogo 666-0261 (JP); MORICHIKA, Kazuo, Takatsuki-shi, Osaka 569-0855 (JP); SAITO, Takao, Toyonaka-shi, Osaka 560-0002 (JP)
(74) Representative: Hart Davis, Jason
(86) International application number: PCT/JP2003/011682
(87) International publication number: WO 2004/026984

(56) References cited:
- EP-A1- 0 854 207
- EP-A2- 0 458 296
- JP-A- 3 112 190
- JP-A- 3 258 865
- JP-A- 9 157 621
- JP-A- 49 102 726
- US-A- 5 543 084
- US-A- 5 676 812
- US-A1- 2002 121 442

## Description

### TECHNICAL FIELD

The present invention relates to a method of adhesion of conductive (electroconductive) materials, to a laminate, and to an adhesive composition.

### BACKGROUND ART

Those adhesives that can be applied to various conductive substrates, such as metal-made substrates, have so far been used extensively. The adhesives, when classified by the principal component, include vinyl acetate resin type, vinyl chloride resin type, vinyl acetate resin emulsion type, synthetic rubber type, and epoxy resin type adhesives, among others.

Such adhesives in conventional use are applied by various methods, such as the spray coating method, spin coating method, roll coating method, and extrusion coating method.

When the spray coating and extrusion coating methods are employed, the adhesive layers obtained by application may be not uniform in film thickness in certain instances. Therefore, in the case of substrates complicated in shape and form, for example molded articles, the spray coating method, spin coating method, roll coating method, and extrusion coating method all cannot give adhesive layers and give uneven layers obtained in film thickness and, as a result, failure may be caused to attain constant and high levels of adhesion strength. Therefore, it has been demanded that a coating method capable of readily forming adhesive layers uniform in film thickness on substrates diverse in shape or form and, as a result, capable of realizing high adhesion strength even in the case of substrates complicated in shape and form be developed.

Furthermore, most of the adhesives in conventional use are not water-based ones but nonaqueous ones. Therefore, in the steps of application, adhesion and heating for curing thereof, the adhesives may emit hazardous materials, such as VOCs (volatile organic compounds) and environmental hormones (endocrine disrupters) and, in some instances, hazardous heavy metals are contained therein. Therefore, the conventional adhesives cannot be said to be environment-friendly. Thus, improvements from such viewpoints have also been desired.

Further, in cases where adhesives are utilized as electric insulating layers in the field of electric and electronic devices, reductions in the thickness of the adhesive layers obtained by applying an adhesive to conductive materials result in insufficient electric insulating properties, leading to dielectric breakdown even at relatively low voltage levels in certain instances. Thus, with the conventional adhesives, it is difficult to reduce the adhesive layer thickness. Improvements have also been demanded from such viewpoints.

Further, from the viewpoint of economy, among others, it has been demanded that a method of adhesion be developed by which sufficient levels of adhesion strength can be obtained even when the adhesive layers formed by applying an adhesive are thin.

### SUMMARY OF THE INVENTION

In view of the above-discussed state of the art, it is an object of the present invention to provide a method of adhesion of conductive materials which uses a water-based ecofriendly adhesive and can give uniform adhesive layers capable of leading to constant and high levels of adhesion strength and excellent in insulating properties even in the case of molded articles and the like.

The present invention provides a method of adhesion of conductive materials comprising the step (1) of forming an adhesive surface having an adhesive resin layer on a conductive material by an electrodeposition step with an adhesive composition and the step (2) of joining an adherend surface of an adhesion target to the adhesive surface having the adhesive resin layer obtained in the step (1),
wherein the adhesive composition comprises a hydratable functional group- and unsaturated bond-containing cationic resin composition.

Preferably, the above adhesive composition is substantially incapable of generating any volatile matter in the step of heating for curing.

The cationic resin composition is preferably one allowing the formation, in the adhesive resin layer, of such chemical species activated by the electrode reaction caused by voltage application in the electrodeposition step as can promote the progress of the curing reaction.

The hydratable functional group is preferably a sulfonium group.

Preferably, the unsaturated bond is at least partly a propargyl carbon-carbon triple bond.

The cationic resin composition preferably has a sulfonium group content of 5 to 400 millimoles, a propargyl group content of 10 to 495 millimoles, and a total content of sulfonium and propargyl groups of not more than 500 millimoles, per 100 g of the solid matter in the cationic resin composition.

The cationic resin composition preferably has a sulfonium group content of 5 to 250 millimoles, a propargyl group content of 20 to 395 millimoles, and a total content of sulfonium and propargyl groups of not more than 400 millimoles, per 100 g of the solid matter in the cationic resin composition.

The cationic resin composition preferably has an epoxy resin as a skeleton .

The epoxy resin is preferably a novolak cresol epoxy resin or novolak phenol epoxy resin and has a number average molecular weight of 700 to 5,000.

The method of adhesion of conductive materials preferably comprises a drying step between the step (1) and step (2).

The step (2) preferably comprises a step of adhesion with heating and a step of curing by heating.

The adherend surface is preferably an adhesive surface having an adhesive resin layer.

Preferably, the adhesion target is a conductive material and the adherend surface is an adhesive surface having an adhesive resin layer formed by an electrodeposition step of a conductive material with an adhesive composition.

The conductive material is preferably made of copper, aluminum, iron, or an alloy mainly composed of these.

The present invention is also concerned with a laminate as obtained by the method of adhesion of conductive materials.

The invention is further concerned with an adhesive composition capable of forming an adhesive resin layer by an electrodeposition step,
wherein the adhesive composition comprises a hydratable functional group- and unsaturated bond-containing cationic resin composition.

### BRIEF DESCRIPTION OF THE DRAWING

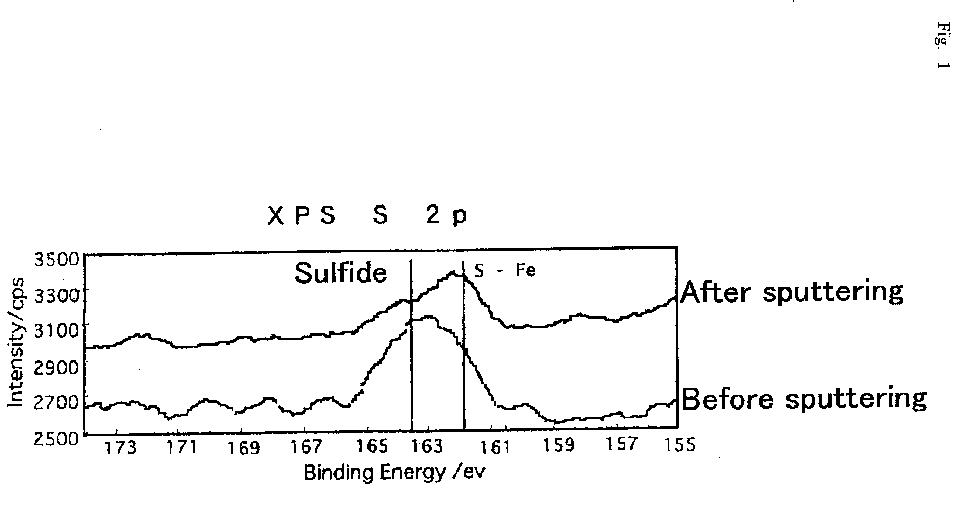

Fig. 1 is a chart showing the results of XPS measurements.

### DETAILED DISCRIPTION OF THE INVENTION

In the following, the present invention is described in detail.

The method of adhesion of conductive materials according to the invention is a method of adhering a conductive material to an adhesion target to each other by forming an adhesive resin layer on the conductive material by carrying out a step of electrodeposition on the conductive material using a cationic resin composition, followed by joining of the adherend surface of the adhesion target to the adhesive resin layer thus formed. By using the above-mentioned method of adhesion of conductive materials, it becomes possible to attain firmly adhering the adhesive surface to adherend surface via the adhesive resin layer formed on the conductive material.

The method of adhesion of conductive materials according to the invention comprises a first step, namely the step (1), in which an adhesive surface having an adhesive resin layer is formed on a conductive material by an electrodeposition step with an adhesive composition, and the adhesive composition to be used in the step (1) comprises a hydratable functional group-and unsaturated bond-containing cationic resin composition.

By carrying out the above step (1), it is possible to form an adhesive resin layer having adhesive properties on the surface of a conductive material and to acquire the conductive material having the adhesive resin layer thus. In this way, it is possible to firmly adhere the adhesive surface of the conductive material to the adherend surface of the adhesion target via the adhesive resin layer formed.

The above adhesive composition can form an adhesive resin layer when the above cationic electrodeposition step, namely the step (1), is carried out, and the layer formed can adhere the adhesive surface to adherend surface of an adhesion target. Thus, the composition can be adequately used as an adhesive.

Unlike the conventional nonaqueous adhesives, the adhesive composition to be used in the above step (1) is a water-based (water-thinned) adhesive and, therefore, the use of VOCs, environmental hormones and other environmental problem substances can be restrained.

Since the adhesive composition used in the above step (1) is applied by an electrodeposition step, it is easy to form a closed system suppressing occurrence to the loss of the adhesive in abundance; as a result, the emission of industrial waste can be reduced as well.

The above adhesive composition can be applied by an electrodeposition step and, therefore, they can be uniformly applied onto substrates having conductivity and can form an adhesive resin layer comprising a cationic resin composition on each substrate. Accordingly, by carrying out the electrodeposition step, the above adhesive composition can be uniformly applied to conductive substrates and, thus, it can be uniformly applied even to substrates complicated in form and shape and an adhesive resin layer can be formed on each substrate with little variation in film thickness.

Since it is a method involving application by an electrodeposition step, the above-mentioned method of adhesion of conductive materials is superior in productivity and economy and is a method relatively low in running cost.

Further, since the above-mentioned step (1) is a step of using the adhesive composition, the substantial emission of volatile components can be suppressed on the occasion of joining the adhesive surface and adherend surface together in the above step (2). This is favorable from the environmental measures viewpoint. The above adhesive composition is excellent in composition stability and affords high levels of adhesion strength after adhesion. Further, it is excellent in electric insulation.

Such effects as mentioned above are the effects obtainable by carrying out an electrodeposition step using the hydratable functional group- and unsaturated bond-containing cationic resin composition in the step (1) of the above-mentioned method of adhesion of conductive materials. They are the effects difficult to produce by the methods of coating using the adhesives in conventional use. Therefore, by using the above cationic resin composition, adhesion of conductive materials can be successfully accomplished as compared with the prior art.

The above adhesion composition comprises a hydratable functional group-containing cationic resin composition. By carrying out the electrodeposition step [step (1)] using the above cationic resin composition and further carrying out the adhesion step [step (2)], it is possible for the composition to manifest good adhesiveness. When the step (1) and step (2) are carried out, the hydratable function group interacts with metal atoms in the conductive material surface and, as a result, the coating film formed on the conductive material firmly adheres to the metal surface. Although the state between the hydratable functional group in the cationic resin composition and metal atoms in the conductive material surface in such a firmly adhered state is not clear, it is supposed, in view of the results of XPS(X-ray photoelectron spectroscopy) measurements, that there is a state like a covalent bond formed between the hydratable functional group and metal atoms in the conductive material surface. The formation of such a state leads to an improvement in the adhesion strength between the adhesive layer and metal surface and, thus, the intended adhesion can be performed without subjecting the metal surface to any special surface treatment. While the particulars of this mechanism are not certain, it is presumable that chemical species are electrolytically formed in the adhesive resin layer and those chemical species form a covalent bond-like state with metal atoms in the conductive material or promote the formation of such a covalent bond-like state. The above-mentioned hydratable functional group is, for example, a sulfonium group or the like.

The occurrence of a covalent bond-like state formed between the above hydratable functional group and metal atoms in the conductive material surface can be confirmed, for example, based on the chemical shift of the 2p orbit sulfide sulfur atom as measured by XPS.

The above adhesive composition is preferably such one that will not allow the substantial emission of any volatile component in the step of heating for curing. When an adhesive resin layer is formed by an electrodeposition step using an adhesive composition and the adhesive resin layer is further cured by heating for the formation of an adhesive resin layer consisting of a cured resin, the vehicle component constituting the adhesive resin layer may partly evaporate in the step of curing in some instances. The emission of such volatile component may cause a decrease or unevenness in adhesion strength. The emission of a volatile component is unfavorable from the environmental viewpoint as well. In cases where there is no substantial volatile component emission from the adhesive composition in the step of curing by heating, the above problems will not arise.

The phrase "there is no substantial volatile component emission" as used herein means that such a volatile component as naturally expected to be emitted in view of the curing reaction will not be emitted. In a curing system in which a blocked isocyanate is used as a curing agent, for instance, it is naturally anticipated that the blocking agent will be emitted as the volatile component and, in a curing system in which curing is attained by a condensation reaction, it is anticipated that a volatile component resulting from the condensation reaction will be emitted. The above adhesive composition allowing no substantial volatile component emission therefrom comprises a cationic resin composition of which no such volatile component emission can be expected. The adhesive composition can be rendered substantially incapable of emitting any volatile component by selecting an appropriate curing system. The volatile component emission-free curing system is not particularly restricted but includes, among others, the propargyl/allene curing system, the curing system involving the Michael addition of an active methylene group to an α,β-unsaturated bond, and the oxidative polymerization curing system.

The above adhesive composition comprises an unsaturated bond-containing cationic resin composition. Thus, the adhesive adhesive resin layer formation is realized by the curing reaction involving polymerization of the unsaturated bond. By this, the emission of volatile components in the step of curing can be reduced, and the adhesion strength is prevented from being decreased or becoming uneven due to the occurrence of a volatile component(s). Such unsaturated bond is not particularly restricted but may be any of those capable of forming curing systems in which the reaction progresses as a result of polymerization of the unsaturated bond. It includes, among others, those unsaturated bonds which form the propargyl/allene system, curing systems involving the Michael addition of an active methylene group to an α,β-unsaturated bond, and oxidative polymerization curing systems.

The "unsaturated bond" so referred to herein means a carbon-carbon double bond or a carbon-carbon triple bond.

The above cationic resin composition is preferably one such that activated chemical species are formed in the adhesive resin layer by the electrode reaction induced by voltage application in the step of electrodeposition and the activated chemical species promote the progress of the curing reaction.

Thus, for promoting the curing reaction in the adhesive resin layer, it is desirable that an electrochemical reaction is induced in advance in the electrodeposition step by voltage application; and, since the progress of the curing reaction is by nature very slow upon mere heating alone, the curing reaction will not proceed in the bath even upon exposure to the Joule heat generated by voltage application, and this is favorable from the bath stability viewpoint. The "progress of the curing reaction" means that a cured film is actually obtained by the curing reaction. Therefore, in cases where the curing reaction occurs as a chemical reaction but no cured film can be obtained, the curing reaction is regarded as making no progress.

Such properties as mentioned above are owing to the generation of chemical species activated by an electrode reaction involving donation and acceptance of electrons on the occasion of adhesive resin layer formation following voltage application to the conductive material and to the involvement of those chemical species in the progress of the reaction for curing the adhesive resin layer.

Such properties as mentioned above are illustrated more specifically. The above-mentioned activated chemical species are generated in the adhesive resin layer as radicals for causing the curing of the adhesive resin layer or as species capable of readily causing the generation of such radicals (e.g. cations, anions), among others, and promote the progress of the curing reaction and other reactions. In cases where the adhesive resin layer curing reaction is initiated in the step of heating, that activated state is maintained until the step of heating.

Both the electrodeposition step and heating step govern the curing of the adhesive resin layer owing to the fact that the above-mentioned adhesive composition has the properties mentioned above. Thus, in the electrodeposition step, the adhesive resin layer is formed and, simultaneously, one or more curing system-constituting essential components are formed to constitute a complete curing system, whereby the adhesive resin layer is prepared for the progress of the curing reaction. In the subsequent heating step, the adhesive resin layer curing reaction proceeds with the help of the curing system completed in the electrodeposition step until completion of the curing. It is a matter of course that the curing reaction can be initiated not only in the heating step but also in the electrodeposition step once the curing system-constituting essential components have been formed.

The mechanism of the electrode reaction in the above adhesive composition as induced by voltage application in the electrodeposition step is represented by the formula (I) or (II) shown below. In the electrodeposition step, the electrode reaction occurs when electrons are donated to the functional groups which the substance (substrate; represented by "S" in the formula) deposited on the electrode has.

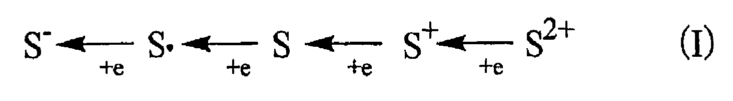

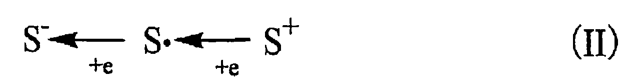

In the reactions represented by the above formulas (I) and (II), the activated chemical species mentioned above are anions and radicals formed in the above reactions. These can be independently involved in the progress of the curing reaction, and two or more species, too, can combinedly provide the same properties. Here, more specifically, the above anion is formed as an electrolytically generated base resulting from electrochemical changes, by the electrode reaction, of the corresponding component contained in the above adhesive composition. On that occasion, strong interaction presumably takes place between the anion formed and the substrate, i.e. metal atoms in the conductive material surface, leading to the formation of a covalent bond-like state.

Since the reactions represented by the above formulas (I) and (II) can be controlled by means of the magnitude of the electrode potential in the above electrode reactions, it is possible to produce the above-mentioned activated chemical species in amounts as needed by controlling the electrode potential.

The above-mentioned electrolytically generated base and radical are not particularly restricted but includes, among others, those generated when a voltage is applied to an onium group, such as an ammonium, sulfonium or phosphonium group, as a supporting electrolyte. When the onium group holds a hydroxide ion formed upon voltage application, it becomes an electrolytically generated base. This electrolytically generated base occurs in the above-mentioned adhesive resin layer and is involved in the curing of the adhesive resin layer. The above onium group can form a radical in the vicinity of the electrode, and this radical, too, can be involved in the curing of the adhesive resin layer mentioned above.

When, for example, an onium group as a hydratable functional group is contained in the base resin, a pigment dispersing resin or some other resin component, or an onium group-containing compound is added as a component other than resin components, the above adhesive composition can provide the activated chemical species in the above electrode reactions.

The above cationic resin composition is preferably a sulfonium group- and propargyl group-containing one.

The sulfonium group, which is an anionic group, in the above-mentioned sulfonium group- and propargyl group-containing cationic resin composition is activated by the electrode reaction induced by voltage application in the electrodeposition step and serves as an origin of radical or anion generation to thereby promote the progress of the curing reaction, and strong interaction takes place between the sulfur atom of the sulfonium group and metal atoms in the conductive material surface, leading to the formation of a covalent bond-like state. The propargyl group causes a curing reaction by polymerization of its unsaturated bond, hence the curing reaction does not generate any volatile component. Further, the reaction of the propargyl group is promoted by a radical or anion derived from the sulfonium group activated by the electrode reaction induced by voltage application in the electrodeposition step. In this way, these two functional groups can efficiently satisfy all the plurality of functions required of the cationic resin composition. Further, the covalent bond-like state resulting from the interaction between the sulfur atom of the sulfonium group and metal atoms in the conductive material surface is formed efficiently and the intensity of the interaction is high, so that the adhesion strength can be improved.

Furthermore, since when the above adhesive composition is used in the step of electrodeposition, even conductive materials complicated in shape and form can be uniformly coated, the composition can be adequately used as an adhesive for members diverse in shape and form.

When the above-mentioned adhesive composition comprises a sulfonium group- and propargyl group-containing cationic resin composition, the component resins of above cationic resin composition may have both a sulfonium group (s) and a propargyl group (s) in each molecule, but this is not absolutely necessary. Thus, for example, the component resins may have only a sulfonium group (s) or only a propargyl group (s) in each molecule. In the latter case, however, the whole resin composition should have both of these two kinds of curable functional groups. Thus, the resin composition may comprise any of sulfonium group- and propargyl group- containing resin, a mixture of a resin having only a sulfonium group (s) and a resin having only a propargyl group(s), and a mixture of all of said kinds of resins. It is herein defined in the above sense that the resin composition has both a sulfonium and a propargyl group(s).

The sulfonium group mentioned above is a hydratable functional group in the above resin composition. When an electric voltage or current exceeding a certain level is applied to the sulfonium group in the electrodeposition step, the group is electrically reduced on the electrode, whereby the ionic group disappears, resulting in irreversible passivation. This is presumably the reason why the above adhesive composition can manifest a high level of throwing power.

It is considered that, in this electrodeposition step, the electrode reaction provoked generates the hydroxide ion, which is held by the sulfonium ion, with the result that an electrolytically generated base is formed in the adhesive resin layer. This electrolytically generated base can convert the propargyl group occurring in the adhesive resin layer and being low in reactivity upon heating to the allene bond high in reactivity upon heating.

The resin to serve as the skeleton of the above cationic resin composition is not particularly restricted but an epoxy resin is suitably used.

Suited for use as the epoxy resin are those having at least two epoxy group within each molecule, including, for example, such epoxy resins as epi-bis-epoxy resins, modifications thereof resulting from chain extension with a diol, dicarboxylic acid or diamine, for instance; epoxidized polybutadiene; novolak phenol polyepoxy resins; novolak cresol polyepoxy resins; polyglycidyl acrylate; polyglycidyl ethers of aliphatic polyols or polyethers polyol; and polyglycidyl esters of polybasic carboxylic acids. Among them, novolak phenol polyepoxy resins, novolak cresol polyepoxy resins and polyglycidyl acrylate are preferred because of the ease of polyfunctionalization for increasing curability. The above epoxy resin may partly comprise a monoepoxy resin.

The above cationic resin composition preferably comprises any of the above-mentioned epoxy resin as a skeleton resins, with a number average molecular weight of 500 (lower limit) to 20, 000 (upper limit). When the molecular weight is less than 500, the coating efficiency in the electrodeposition step will be poor and, when it exceeds 20, 000, any good adhesive resin layer will be formed no longer on the conductive material surface. The number average molecular weight can be selected within a more preferred range according to the resin skeleton. In the case of novolak phenol epoxy resins and novolak cresol epoxy resins, for instance, the lower limit is preferably 700 and the upper limit is preferably 5,000.

The sulfonium group content in the above cationic resin composition should satisfy the condition concerning the total content of the sulfonium and propargyl groups, which is to be described later herein, and, in addition, the lower limit thereto is preferably set at 5 millimoles and the upper limit at 400 millimoles, per 100 g of the solid matter in the above cationic resin composition. When it is lower than 5 millimoles/100 g, no satisfactory throwing power and curability can be attained and deteriorations may result in hydratability and bath stability. When it exceeds 400 millimoles/100 g, the adhesive resin layer deposition on the conductive material surface will become poor. The sulfonium group content can be selected within a more preferred range determined according to the resin skeleton employed. In the case of novolak phenol epoxy resins and novolak cresol epoxy resins, for instance, the above-mentioned lower limit is more preferably 5 millimoles, still more preferably 10 millimoles, and the upper limit is more preferably250millimoles, still more preferably 150 millimoles, per 100 g of the solid matter in the cationic resin composition.

The propargyl group in the above cationic resin composition serves as a curable functional group in the adhesive composition. Further, for unknown reasons, the combined use thereof with a sulfonium group can further improve the throwing power of the adhesive composition.

The propargyl group content in the above cationic resin composition should satisfy the condition concerning the total content of the sulfonium and propargyl groups, which is to be described later herein, and, in addition, the lower limit thereto is preferably set at 10 millimoles and the upper limit at 495 millimoles, per 100 g of the solid matter in the above cationic resin composition. When it is lower than 10 millimoles/100 g, no satisfactory throwing power and curability can be attained and, when it exceeds 495 millimoles/100 g, the hydration stability may be adversely affected. The propargyl group content can be selected within a more preferred range according to the resin skeleton employed. In the case of novolak phenol epoxy resins and novolak cresol epoxy resins, for instance, the above-mentioned lower limit is more preferably 20 millimoles, and the upper limit is more preferably 395 millimoles, per 100 g of the solid matter in the cationic resin composition.

The total content of the sulfonium and propargyl groups in the above cationic resin composition is preferably not higher than 500 millimoles per 100 g of the solid matter in the cationic resin composition. If it exceeds 500 millimoles/100 g, no resin may be actually obtained or no desired performance characteristics may be obtained. The total content of the sulfonium and propargyl groups in the above cationic resin composition can be selected within a more preferred range according to the resin skeleton employed. In the case of novolak phenol epoxy resins and novolak cresol epoxy resins, for instance, the total content is more preferably not higher than 400 millimoles.

The propargyl group in the above cationic resin composition may be partly converted to an acetylide. The acetylide is an acetylene bond-containing metal compound resembling a salt. As for the content of the acetylide-form propargyl group in the above cationic resin composition, the lower limit hereto is preferably 0.1 millimole and the upper limit 40 millimoles, per 100 g of the solidmatter in the cationic resin composition. At content levels below 0.1 millimole, the effect of conversion to acetylides will not be produced to a satisfactory extent and, at content levels exceeding 40 millimoles, the conversion to acetylides is difficult. This content can be selected in a more preferred range according to the metal species employed.

The metal contained in the above-mentioned acetylide-form propargyl group is not particularly restricted but may be any of those metals which exhibit a catalytic activity, for example copper, silver, barium and other transition metals. From the viewpoint of applicability to the environment, copper and silver are preferred and, in view of availability, copper is more preferred. When copper is used, the content of the acetylide-form propargyl group in the above cationic resin composition is more preferably 0.1 to 20 millimoles per 100 g of the solid matter in the cationic resin composition.

Conversion of part of the propargyl group in the above resin composition to an acetylide can result in introduction of a curing catalyst into the resin. By doing so, it becomes unnecessary to use an organic transition metal complex generally soluble or dispersible only scarcely in organic solvents and water. Even a transition metal can be readily introduced after conversion to an acetylide into the resin, so that even a scarcely soluble transition metal compound can be freely used. Further, the occurrence of an organic acid salt as an anion in the electrodeposition bath, which is encountered when a transition metal organic acid salt is used, can be avoided and, furthermore, the metal ion will not be removed upon ultrafiltration, hence the bath management and adhesive composition designing become easy.

Where desired, the above cationic resin composition may contain a carbon-carbon double bond. The carbon-carbon double bond is highly reactive, so that the curability can be further improved.

The carbon-carbon double bond content should satisfy the condition concerning the total content of the propargyl group and carbon-carbon double bond, which is to be described later herein, and, in addition, the lower limit thereto is preferably 10 millimoles and the upper limit at 485 millimoles, per 100 g of the solid matter in the above cationic resin composition. When it is lower than 10 millimoles/100 g, no satisfactory curability can be attained by the addition thereof and, when it exceeds 485 millimoles/100 g, the hydration stability may be adversely affected. The carbon-carbon double bond content can be selected within a more preferred range according to the resin skeleton employed. In the case of novolak phenol epoxy resins and novolak cresol epoxy resins, for instance, the above-mentioned lower and upper limits are preferably 20 millimoles and 375 millimoles, respectively, per 100 g of the solid matter in the cationic resin composition.

When the resin composition contains the above-mentioned carbon-carbon double bond, the total content of the propargyl group and carbon-carbon double bond is preferably within the range from 80 millimoles (lower limit) to 450 millimoles (upper limit) per 100 g of the solid matter in the resin composition. At content levels lower than 80 millimoles/100 g, the curability may be unsatisfactory and, at levels exceeding 450 millimoles/100 g, the sulfonium group content becomes decreased and the throwing power may become insufficient. The above total content of the propargyl group and carbon-carbon double bond can be selected within a more preferred range according to the resin skeleton employed. In the case of novolak phenol epoxy resins and novolak cresol epoxy resins, for instance, the above mentioned lower and upper limits are more preferably 100 millimoles and 395 millimoles, respectively, per 100 g of the solid matter in the cationic resin composition.

When the resin composition contains the above carbon-carbon double bond, the total content of the above sulfonium and propargyl groups and carbon-carbon double bond is preferably not higher than 500 millimoles per 100 g of the solid matter in the resin composition. When it exceeds 500 millimoles/100 g, no resin can be actually obtained or some or other desired performance characteristics may be no longer obtained. The above total content of the sulfonium and propargyl groups and carbon-carbon double bond can be selected within a more preferred range according to the resin skeleton employed. In the case of novolak phenol epoxy resins and novolak cresol epoxy resins, for instance, it is preferably not higher than 400 millimoles per 100 g of the solid matter in the cationic resin composition.

The above cationic resin composition can suitably be produced, for example, by the step (i) of reacting an epoxy resin having at least two epoxy groups in each molecule with a compound having a functional group capable of reacting with the epoxy group and, further, a propargyl group to give a propargyl group-containing epoxy resin composition and the step (ii) of reacting the residual epoxy groups in the propargyl group-containing epoxy resin composition obtained in step (i) with a sulfide/acid mixture for sulfonium group introduction.

The above-mentioned compound having a functional group capable of reacting with the epoxy group and, further, a propargyl group (hereinafter referred to as "compound (A) ") may be, for example, a compound having both a functional group capable of reacting with the epoxy group, such as a hydroxyl or carboxyl group, and a propargyl group. As specific examples, there may be mentioned propargyl alcohol and propargylic acid, among others. Among these, propargyl alcohol is preferred in view of its availability and good reactivity.

For providing the cationic resin composition with a carbon-carbon double bond according to need, a compound having a functional group capable of reacting with the epoxy group and, further, a carbon-carbon double bond (hereinafter referred to as "compound (B)") is used in combination with the above-mentioned compound (A). The compound (B) may be a compound having both a functional group capable of reacting with the epoxy group, such as a hydroxyl or carboxyl group, and a carbon-carbon double bond. Specifically, when the group reacting with the epoxy group is a hydroxyl group, there may be mentioned 2-hydroxyethyl acrylate, 2-hydroxyethyl methacrylate, hydroxypropyl acrylate, hydroxypropyl methacrylate, hydroxybutyl acrylate, hydroxybutyl methacrylate, allyl alcohol, methallyl alcohol, and the like. When the group reacting with the epoxy group is a carboxyl group, there may be mentioned, among others, acrylic acid, methacrylic acid, ethacrylic acid, crotonic acid, maleic acid, phthalic acid, itaconic acid; half esters such as maleic acid ethyl ester, fumaric acid ethyl ester, itaconic acid ethyl ester, succinic acid mono(meth)acryloyloxyethyl ester, and phthalic acid mono(meth)acryloyloxyethyl ester; oleic acid, linolic acid, ricinolic acid, and like synthetic unsaturated fatty acids; and linseed oil, soybean oil, and like nature-derived unsaturated fatty acids.

In the above step (i), the epoxy resin having at least two epoxy groups in each molecule is reacted with the above compound (A) to give a propargyl group-containing epoxy resin composition or with the above compound (A) and the above compound (B) as necessary to give a propargyl group- and carbon-carbon double bond-containing epoxy resin composition. In the latter case, in the step (i), the compound (A) and compound (B) may be mixed together in advance and then subjected to reaction, or the compound (A) and compound (B) may be separately subjected to reaction. That functional group reacting with the epoxy group which the compound (A) has and that functional group reacting with the epoxy group which the compound (B) has may be the same or different.

When, in the above step (i), the compound (A) and compound (B) are subjected to reaction with the epoxy resin, the proportion between both compounds may be selected so that a desired functional group content may be obtained, for example that the above-mentioned propargyl group and carbon-carbon double bond contents may be obtained.

As for the reaction conditions in the above step (i), the reaction is generally carried out at room temperature or 80 to 140°C for several hours. If necessary, one or more known ingredients necessary for the progress of the reaction, such as a catalyst and/or solvent, may be used. The completion of the reaction can be checked by epoxy equivalent determination, and the functional group introduced can be confirmed by analysis of nonvolatile fraction and instrumental analysis of the resin composition obtained. The thus-obtained reaction product generally occurs as a mixture of epoxy resins having one or a plurality of propargyl groups, or a mixture of epoxy resins having one or a plurality of propargyl groups and carbon-carbon double bonds. In this sense, the resin composition obtained in the above step (i) is a propargyl group-containing one or a propargyl group- and carbon-carbon double bond-containing one.

In the step (ii), the residual groups in the propargyl group-containing epoxy resin composition obtained in the above step (i) are reacted with a sulfide/acid mixture for sulfonium group introduction. This introduction of the sulfonium group can be effected by the method which comprises causing the sulfide/acid mixture to react with the epoxy group to effect introduction of the sulfide and conversion thereof to the sulfonium group or the method which comprises introducing a sulfide and then converting the introduced sulfide to a sulfonium group with an acid, an alkyl halide, such as methyl fluoride, methyl chloride or methyl bromide, or the like reagent, if necessary, followed by anion exchange. In view of the availability of the reactant, the method using a sulfide/acid mixture is preferred.

The above sulfide is not particularly restricted but includes, among others, aliphatic sulfides, aliphatic-aromatic mixed sulfides, aralkyl sulfides, and cyclic sulfides. Specifically, there may be mentioned, for example, diethyl sulfide, dipropyl sulfide, dibutyl sulfide, dihexyl sulfide, diphenyl sulfide, ethyl phenyl sulfide, tetramethylene sulfide, pentamethylene sulfide, thiodiethanol, thiodipropanol, thiodibutanol, 1-(2-hydoxyethylthio)-2-propanol, 1-(2-hydroxyethylthio)-2-butanol, and 1-(2-hydroxyethylthio)-3-butoxy-1-propanol.

The above-mentioned acid is not particularly restricted but includes, among others, formic acid, acetic acid, lactic acid, propionic acid, boric acid, butyric acid, dimethylolpropionic acid, hydrochloric acid, sulfuric acid, phosphoric acid, N-acetylglycine, and N-acetyl-β-alanine.

The mixing ratio between the sulfide and acid in the above sulfide/acid mixture is generally and preferably about 100/40 to 100/100 as expressed in terms of sulfide/acid mole ratio.

The reaction in the above step (ii) can be carried out, for example, by mixing the propargyl group-containing epoxy resin composition obtained in the above step (i) and the above sulfide/acid mixture in an amount selected so as to give the above-mentioned sulfonium group content, for instance, with water in an amount of 5 to 10 moles per mole of the sulfide used and stirring the mixture generally at 50 to 90°C for several hours. A residual acid value of 5 or below may serve as a criterion in judging the reaction to be at the end point. The sulfonium group introduction in the resin composition obtained can be confirmed by potentiometric titration.

The same procedure can be used also in the case where the sulfide is first introduced and then converted to the sulfonium group. By carrying out introduction of the sulfonium group after introduction of the propargyl group, as mentioned above, the sulfonium group can be prevented from being decomposed upon heating.

When the propargyl group in the above resin composition is partly converted to an acetylide, conversion to the acetylide can be carried out by the step of reacting the propargyl group-containing epoxy resin obtained in the above step (i) with a metal compound to thereby convert part of the propargyl group in the above-mentioned epoxy resin composition to the corresponding acetylide. The metal compound is preferably a transition metal compound capable of giving an acetylide and includes, among others, complexes or salts of such transition metals as copper, silver and barium. Specifically, there may be mentioned, for example, acetylacetonato-copper, copper acetate, acetylacetonato-silver, silver acetate, silver nitrate, acetylacetonato-barium, and barium acetate. Among these, copper or silver compounds are preferred from the environmental friendliness viewpoint, and copper compounds are more preferred because of their ready availability. For example, acetylacetonato-copper is suitably used in view of the ease of bath control.

As regards the reaction conditions for converting partly the propargyl group to an acetylide, the reaction is generally carried out at 40 to 70°C for several hours. The progress of the reaction can be checked by the coloration of the resulting resin composition and/or the disappearance of the methine proton signal on a nuclear magnetic resonance spectrum. The time when the propargyl group-derived acetylide in the cationic resin composition arrives at a desired level is thus determined and, at that time, the reaction is terminated. The reaction product obtained is generally a mixture of epoxy resins with one or a plurality of propargyl groups converted to an acetylide. A sulfonium group can be introduced, by the above step (ii), into the thus obtained epoxy resin composition with the propargyl group partly converted to an acetylide.

The step of partly converting the propargyl group in the epoxy resin composition to an acetylide and the step (ii) can be carried out under common reaction conditions, so that both steps can be carried out simultaneously. The production process can be advantageously simplified by carrying out both steps simultaneously.

In this way, the propargyl group- and sulfonium group-containing resin composition optionally containing a carbon-carbon double bond and/or a propargyl group-derived acetylide according to need can be produced while preventing the sulfonium group from being decomposed. Although acetylides in a dry state are explosive, the reaction in the practice of the invention is carried out in an aqueous medium and the desired substance can be obtained in the form of an aqueous composition. Therefore, there arises no safety problem.

Since the above-mentioned adhesive composition comprises the above-mentioned cationic resin composition and the cationic resin composition itself is curable, it is not always necessary to use the adhesive composition. However, for further improving the curability, a curing agent may be used. As such curing agent, there may be mentioned, among others, compounds having a plurality of propargyl groups and/or carbon-carbon double bonds, for example compounds obtained by subjecting a propargyl group-containing compound, such as propargyl alcohol, or a carbon-carbon double bond-containing compound, such as acrylic acid, to addition reaction to a novolak phenol- or like compound-derived polyepoxide or pentaerythritol tetraglycidyl ether.

It is not always necessary to use the adhesive composition in the above cationic electrodeposition coating composition. However, when a further improvement in curability is required depending on the curing reaction conditions, a transition metal compound in general use, for instance, may be added in an appropriate amount according to need. Such compound is not particularly restricted but includes, among others, complexes or compounds resulting from combination with a ligand, such as cyclopentadiene or acetylacetone, or a carboxylic acid, such as acetic acid, to transition metals such as nickel, cobalt, manganese, palladium, and rhodium. The level of addition of the above curing catalyst is preferably from 0.1 millimole (lower limit) to 20 millimoles (upper limit) per 100 g of the resin solids in the adhesive composition.

An amine may further be incorporated in the above adhesive composition. By the addition of the amine, the conversion of the sulfonium group to a sulfide by electrolytic reduction in the process of electrodeposition is increased. The amine is not particularly restricted but includes, among others, amine compounds such as primary to tertiary monofunctional or polyfunctional aliphatic amines, alicyclic amines and aromatic amines. Among these, water-soluble or water-dispersible ones are preferred and, thus, mention may be made of C₂₋₈ alkylamines such as monomethylamine, dimethylamine, trimethylamine, triethylamine, propylamine, diisopropylamine and tributylamine; monoethanolamine, dimethanolamine, methylethanolamine, dimethylethanolamine, cyclohexylamine, morpholine, N-methylmorpholine, pyridine, pyrazine, piperidine, imidazoline, imidazole and the like. These may be used singly or two or more of them may be used in combination. Among them, hydroxy amines such as monoethanolamine, diethanolamine and dimethylethanolamine are preferred from the view point of excellent dispersion stability in water. The above amine can be directly incorporated in the above adhesive composition.

The level of addition of the above amine is preferably 0. 3 milliequivalents (meq) (lower limit) to 25 meq (upper limit) per 100 g of the resin solid matter in the adhesive composition. If it is less than 0.3 meq/100 g, any sufficient effect on the throwing power cannot be obtained. If it exceeds 25 meq/100 g, the effects proportional to the addition level can no longer be obtained; this is not economical. The lower limit is more preferably 1 meq/100 g, and the upper limit is more preferably 15 meq/100 g.

In the above adhesive composition, there may be incorporated an aliphatic hydrocarbon group-containing resin composition. The incorporation of the aliphatic hydrocarbon group-containing resin composition improves the impact resistance of the adhesive resin layer after curing. The aliphatic hydrocarbon group-containing resin composition includes those containing, per 100 g of the solid matter in the resin composition, 5 to 400 millimoles of a sulfonium group, 80 to 135 millimoles of a C₈₋₂₄ aliphatic hydrocarbon group, which may optionally contain an unsaturated double bond in the chain thereof, and 10 to 315 millimoles of at least one of an unsaturated double bond-terminated C₃₋₇ organic group and a propargyl group, with the total content of the sulfonium group, the C₈₋₂₄ aliphatic hydrocarbon group, which may optionally contain an unsaturated double bond in the chain thereof, the unsaturated double bond-terminated C₃₋₇ organic group and the propargyl group being not higher than 500 millimoles per 100 g of the solid matter in the resin composition.

When such aliphatic hydrocarbon group-containing resin composition is incorporated in the above-mentioned adhesive composition, each 100 g of the resin solid matter in the adhesive composition preferably contains 5 to 400 millimoles of the sulfonium group, 10 to 300 millimoles of the C₈₋₂₄ aliphatic hydrocarbon group, which may optionally contain an unsaturated double bond in the chain thereof, and 10 to 485 millimoles of the propargyl group and unsaturated double bond-terminated C₃₋₇ organic group in total, the total content of the sulfonium group, the C₈₋₂₄ aliphatic hydrocarbon group, which may optionally contain an unsaturated double bond in the chain thereof, the propargyl group and the unsaturated double bond-terminated C₃₋₇ organic group is preferably not higher than 500 millimoles per 100 g of the resin solid matter in the adhesive composition, and the content of the above C₈₋₂₄ aliphatic hydrocarbon group, which may optionally contain an unsaturated double bond in the chain thereof, is preferably 3 to 30% by mass based on the resin solid matter in the adhesive composition.

In cases where the aliphatic hydrocarbon group-containing resin composition is incorporated in the above adhesive composition, when the sulfonium group content is below 5 millimoles/100 g, no sufficient throwing power and curability can be exhibited and deteriorations in hydratability and bath stability will result. When it exceeds 400 millimoles/100 g, the adhesive resin layer deposition on the conductive material surface becomes poor. When the content of the C₈₋₂₄ aliphatic hydrocarbon group, which may optionally contain an unsaturated double bond in the chain thereof, is less than 80 millimoles/100 g, the improvement in impact resistance will be unsatisfactory and, when it exceeds 350 millimoles/100 g, the resin composition becomes difficult to handle. When the total content of the propargyl group and the C₃₋₇ unsaturated double bond-terminated organic group is lower than 10 millimoles/100 g, no satisfactory curability will be produced even when another resin and/or a curing agent is used combinedly. When it exceeds 315 millimoles/100 g, the impact resistance will be improved only to an unsatisfactory extent. The total content of the sulfonium group, the C₈₋₂₄ aliphatic hydrocarbon group, which may optionally contain an unsaturated double bond in the chain thereof, the propargyl group and the C₃₋₇ unsaturated double bond-terminated organic group is not more than 500 millimoles per 100 g of the solid matter in the cationic resin composition. When it exceeds 500 millimoles, no resin will be actually obtained or the desired performance characteristics may not be obtained.

The above adhesive composition can be prepared, for example, by admixing the above cationic resin composition with the above-mentioned other ingredients according to need and dissolving or dispersing the resulting composition in water. On the occasion of use in the electrodeposition step, the bath solution/dispersion prepared preferably has a nonvolatile matter content of 10% by mass (lower limit) to 30% by mass (upper limit). The preparation is preferably carried out so that the contents of the propargyl group, carbon-carbon double bond and sulfonium group in the adhesive composition may not deviate from the respective ranges indicated hereinabove referring to the resin composition.

The above-mentioned conductive material is not particularly restricted but may be any of those substrates which show electric conductivity for enabling the electrodeposition coating step, for example metal moldings, such as sheets or plates and molded articles, made of iron, copper, aluminum, gold, silver, nickel, tin, zinc, titanium, tungsten or the like, or an alloy containing such metals. Among them, conductive materials made of copper, aluminum or iron or an alloy comprising these as main constituents are particularly suited for adhesion, since high levels of adhesion strength can be obtained with them.

The adhesive resin layer formed in the above step (1) is preferably one formed from a sulfonium group- and propargyl group-containing cationic resin composition. By this, it is possible to form an adhesive resin layer having high adhesiveness to the adhesion surface of the conductive material and high adhesiveness to the adherend surface of the adhesion target article.

As the method of carrying out the electrodeposition step in the above step (1), there may be mentioned, for example, the method comprising immersing the above conductive material in the above adhesive composition for utilizing the conductive material as a cathode, and applying a voltage generally within the range of 50 to 450 V between the cathode and anode. When the voltage applied is lower than 50 V, insufficient electrodeposition will result. At a voltage exceeding 450 V, the electricity consumption uneconomically increases. When the above adhesive composition is used and a voltage within the above range is applied, a uniform adhesive resin layer can be formed on the whole conductive material surface, without any rapid increase in film thickness in the process of electrodeposition. In ordinary cases, the adhesive composition bath temperature when the above voltage is applied is preferably 10 to 45°C. On the other hand, the voltage application time may vary depending on the electrodeposition conditions but, generally, it may be 0.3 second to 4 minutes.

In the method of adhesion of conductive materials of the invention, a drying step may be carried out after conducting the above electrodeposition step. The drying step is the step of heating the conductive material with an adhesive surface formed thereon in a temperature range within which no curing reaction occurs. When such drying is conducted, the volatile materials, such as the solvent, remaining in the adhesive surface can be thoroughly removed to attain further improvement and uniformity in adhesion strength. The above drying is preferably carried out by heating within a temperature range from a lower limit of room temperature, preferably a lower limit of 50°C, to an upper limit of 100°C for 5 to 20 minutes.

The second step in the method of adhesion of conductive materials of the invention is the step (2) of joining an adherend surface of an adhesion target to the adhesive surface having the adhesive resin layer obtained in the step (1).

By carrying out the above step (2), the adhesive surface having the adhesive resin layer formed in the above step (1) and the adherend surface of adhesion target article can be firmly adhered together via the adhesive resin layer formed. The above step (2) can be carried out, for example, by bringing the adhesive surface having the adhesive resin layer obtained by carrying out the above step (1) into contact with the adherend surface of the adhesion target article and then curing the adhesive resin layer by heating. By this, firm adhesions can be obtained between the conductive material and adhesive resin layer and between the adhesion target article and adhesive resin layer and, as a result, the conductive material and the adhesion target article can be firmly adhered together via the above adhesive resin layer. In particular, it is supposed that strong interaction occurs between the conductive material and adhesive resin layer for forming a covalent bond-like state and, thus, firmer adhering can result.

The above-mentioned adhesion target article is not particularly restricted but may be any of those made of a material to which the above-mentioned adhesive resin layer shows adhesiveness. Thus, for example, various substrates arbitrarily selected can be used, for example those conductive materials used in the above step (1), plastics moldings, foamed plastics, and so forth.

As the above plastics moldings, there may be mentioned, for example, plates and other moldings made of polypropylene resins, polycarbonate resins, urethane resins, polyester resins, polystyrene resins, ABS resins, vinyl chloride resins, polyamide resins, and so on.

The above step (2) preferably comprises a heating/adhesion step and a heating/curing step. The heating/adhesion step is the step of heating insufficient for causing the curing reaction of the adhesive resin layer but sufficient for melting the adhesive resin layer of the adhesive surface and attaching thereto the adherend surface of the adhesion target. This brings the conductive material and the adhesion target into close contact with each other. In cases where the conductive material and adhesion target each has an adhesive resin layer on the adhesive surface, both the adhesive resin layers are melted and fused together in the above heating/adhesion step to give one uniform adhesive layer. Such a uniform adhesive layer resulting from fusion contributes to further improvement in adhesion strength.

As for the heating conditions in the above heating/adhesion step, the heating is preferably carried out at 70 to 120°C for 5 to 20 minutes. Heating below the above lower limits may fail to attain satisfactory intimate adhesion between the conductive material and adhesion target. Heating exceeding the above upper limits allows the adhesive resin layer to cure before close adhesion thereof to the adhesion target, so that the adhesion strength may decrease. The above heating/curing step is the step of firmly brining the adhesive surface and adherend surface into close contact and curing the adhesive resin layer by further heating to thereby attain firm adhering the adhesive surface to adherend surface as a result of curing.

As for the heating conditions in the above heating/curing step, the adhesive resin layer-mediated firm adhering the adhesive surface to adherend surface can be attained by curing the adhesive resin layer by heating at 120 to 260°C, preferably at 160 to 240°C, for 10 to 30 minutes. Heating below the above lower limits may result in insufficient curing, hence in a decrease in adhesion strength. Heating exceeding the above upper limits will produce no further improvement in adhesion strength, hence may be uneconomical. The above heating/adhesion step and heating/curing step may be carried out successively.

The above step (2) is preferably carried out using a vacuum press apparatus. When the adhesive surface and adherend surface are joined together using a vacuum press apparatus, bubbles contained in the adhesive resin layer in the step of joining can be eliminated. Thus, the adhesion strength of the resulting laminate can be further improved. The above-mentioned vacuum press apparatus may be any of those known in the art.

The adherend surface in the adhesion target article is preferably an adhesive surface having an adhesive resin layer. The adhesive resin layer is not particularly restricted but may be an adhesive resin layer well known to those skilled in the art, for example a layer resulting from application of an adhesive in conventional use. It is desirable, however, that a conductive material having an adhesive resin layer obtained by carrying out the above-mentioned step (1) be used as the adhesion target article, with the adhesive resin layer so formed being employed as the adherend surface. In this case, it is supposed that the adhesive resin layers can be brought into contact with each other and then cured and, after curing strong interaction between the respective conductive materials and the adhesive resin layer occurs and, as a result, the adhesion strength between the adhesive surface and adherend surface can be further improved.

The laminate obtained by the above-mentioned method of adhesion of conductive materials is high in the adhesion strength between the conductive material and adhesion target article and therefore can be used in those fields where high adhesion strength is required. Such laminate also constitutes an aspect of the present invention.

The present invention is also concerned with an adhesive composition for forming adhesive resin layers by the step of electrodeposition which composition comprises a hydratable functional group- and unsaturated bond-containing cationic resin composition. By using the above adhesive composition in the step of electrodeposition, it is possible to form an adhesive resin layer on a conductive material and cause strong interaction between the hydratable functional groups in the adhesive resin layer formed and metal atoms in the conductive material surface. The covalent bond-like state formed as a result of this interaction is firm and strong and, therefore, the above adhesive composition can be adequately applied to conductive materials.

The method of adhesion of conductive materials of the invention comprises the step (1) of forming an adhesive surface having an adhesive resin layer on a conductive material by carrying out an electrodeposition step with an adhesive composition comprising a hydratable functional group- and unsaturated bond-containing cationic resin composition and the step (2) of joining an adherend surface of adhesion target to the adhesive surface having the adhesive resin layer obtained by the above step (1). Therefore, the above-mentioned method of adhesion of conductive materials is an environment-friendly method, and is a method excellent in the uniformity in the film thickness of the resulting the adhesive resin layer, in productivity and economy, and in the adhesion strength after adhering. It is also a method capable of readily and uniformly coating conductive materials complicated in shape and form as well. In particular, when the conductive material is metal and the above adhesive composition comprises a sulfonium group- and propargyl group-containing cationic resin composition, the adhesive resin layer formed has the sulfonium groups and, therefore, strong interaction presumably occurs between the sulfur atoms and the metal atoms in the conductive material surface, leading to formation of a covalent bond-like state after curing by heating. Presumably, this can result in firmer adhesion. It is essential that an electrochemical reaction be induced by voltage application in the electrodeposition step; mere heating alone cannot allow the curing reaction to proceed. Accordingly, it is superior in stability as well. Therefore, the above-mentioned method of adhesion of conductive materials can be adequately applied to adhesion of various conductive materials.

The method of adhesion of conductive materials of the invention, which has the constitution described above, can give laminates high in adhesion strength. The above method of adhesion of conductive materials is excellent in productivity and economy and in the uniformity in film thickness of the resulting the adhesive resin layer, and is desirable also from the environmental viewpoint. It is a method by which even conductive materials complicated in shape and form, which are difficult to coat by the conventional methods, can be coated with ease. Therefore, the method of adhesion of conductive materials of the invention can be adequately applied to various conductive materials, such as metal substrates.

### EXAMPLES

The following examples illustrate the present invention more specifically. These examples are, however, by no means limitative of the scope of the invention. In the examples, "part(s)" means "parts by mass", unless otherwise specified.

### Production Example 1

### Production of a sulfonium group- and propargyl group-containing epoxy resin composition

Epototo YDCN-701 (100.0 parts) with an epoxy equivalent of 200.4 (cresol novolak-based epoxy resin, product of Toto Chemical), 23.6 parts of propargyl alcohol, and 0.3 part of dimethylbenzylamine were placed in a separable flask equipped with a stirrer, thermometer, nitrogen inlet tube and reflux condenser, the mixture was heated to 105°C, and the reaction was allowed to proceed at that temperature for 3 hours to give a propargyl group-containing resin composition with an epoxy equivalent of 1,580. To this was added 2.5 parts of acetylacetonato-copper, and the reaction was allowed to proceed at 50°C for 1.5 hours. It was confirmed that part of the terminal hydrogens of the added propargyl groups was disappeared by proton (1H) NMR (propargyl converted to acetylide: 14 millioles/100 g of the resin solid matter). To this were added 10.6 parts of 1-(2-hydroxyethylthio)-2,3-propanediol, 4.7 parts of glacial acetic acid and 7.0 parts of deionized water, and the reaction was allowed to proceed for 6 hours while maintaining the temperature at 75°C. After confirmation that the residual acid value is less than 5, 43.8 parts of deionized water was added to give a desired resin composition solution. This solution had a solid matter content of 70.0% by mass, and the sulfonium value was 28.0 millimoles/100 g. The number average molecular weight (determined by GPC on the polystyrene equivalent basis) was 2,443.

### Example 1

### Production of an adhesive composition

The epoxy resin composition obtained in Production Example 1 (142.9 parts) and 157.1 parts of deionized water were stirred in a high-speed rotary mixer for 1 hour and, then, 373.3 parts of deionized water was further added to prepare an aqueous solution with a solid matter concentration of 15% by mass. An adhesive composition was thus obtained.

### [Production of laminate 1]

One surface of a 250-mm square aluminum sheet with a thickness of 5 mm was masked with a readily releasable resin-made masking tape for avoiding adhesion sticking thereto. Then, an adhesive resin layer was formed on the other surface by electrodeposition coating with the adhesive composition obtained, whereby an adhesive resin layer-carrying aluminum sheet was obtained.

The thus-obtained adhesive resin layer-carrying aluminum sheet was dried in a drying oven with hot air circulation at 90°C for 10 minutes to form a dried adhesive resin layer. This dried adhesive resin layer was not tacky at room temperature and became tacky at a temperature above 60°C. In that dried state, the dried adhesive resin layer had a thickness of 15 to 20 µm.

The masking tape was peeled off from the dried aluminum sheet, a 80 x 10 mm copper sheet with a thickness of 0.7 mm was placed on the aluminum sheet with one face of the copper sheet facing the dried adhesive resin layer -carrying surface of the aluminum sheet, and both the metal sheets were pressed to each other using a vacuum press apparatus set at 190°C to attain lamination and adhesion between the aluminum sheet and copper sheet. The dried adhesive resin layer was then cured by 25 minutes of heating at 190°C, whereby a laminate (laminate 1) was obtained. The vacuum press conditions were as follows: 0.5 MPa, 3 seconds.

### Example 2

A laminate (laminate 2) was obtained in the same manner as in Example 1 except that a polypropylene sheet (thickness 2 mm, 80 x 10 mm) was used in lieu of the copper sheet used in Example 1.

### Example 3

### Step (1)

One surface of each of two 49 x 12 mm copper sheets with a thickness of 1.5 mm was masked with a readily releasable resin-made masking tape for avoiding adhesion sticking thereto. Then, an adhesive resin layer was formed on the other surface of each sheet by electrodeposition coating with the adhesive composition obtained, whereby two adhesive resin layer-carrying copper sheets were obtained.

### Step (2)

The thus-obtained adhesive resin layer-carrying copper sheets were each dried in a drying oven with hot air circulation for dried adhesive resin layer formation at 90°C for 10 minutes. This dried adhesive resin layer was not tacky at room temperature and became tacky at a temperature above 60°C. In that dried state, the dried adhesive resin layer had a thickness of 15 to 20 µm.

The masking tape was peeled off from each dried copper sheet, the copper sheets were placed one on another so that the dried adhesive resin layer faced to each other might form an adhesion area of 12 mm square, and both the sheets were pressed together using a vacuum press apparatus set at 190°C to attain lamination/adhesion and simultaneous curing of the dried adhesive resin layer to give a laminate (laminate 3). The vacuum press conditions were as follows: 0.5 MPa, 25 minutes.

### Example 4

One surface of a 70 x 150 mm iron sheet with a thickness of 0.8 mm was masked with a readily releasable resin-made masking tape for avoiding dried adhesive resin layer. Then, an adhesive resin layer was formed on the other side by electrodeposition coating with the adhesive composition obtained, whereby an adhesive resin layer-carrying iron sheet was obtained.

The adhesive resin layer of the thus-obtained adhesive resin layer-carrying iron sheet was dissolved using tetrahydrofuran (THF), and a 10 mm square sample was excised from the sheet.

The surface condition (state of the iron and adhesive resin layer) of this sample was observed using "AXIS-HS" (XPS, product of Shimadzu Corp.). The measurement results are shown in Fig. 1. When the sample as such was measured, the interface between the residual coating film and iron could not be observed because the thickness of that film was greater than the depth of analysis. A peak (163.7 eV) ascribable to the sulfide occurring in the coating film was observed. After removal, to a certain extent, of the coating film by sputtering, the interface with iron became analyzable and a peak (161.9 eV) ascribable to S-Fe was observed. From these results, it was revealed that interaction (between S and Fe) occurred between the adhesive resin layer formed and the iron sheet and a covalent bond-like state was formed in the electrodeposition coating.

### Example 5

An iron sheet and a copper sheet each having a thickness of 0.8 mm and a 70 x 150 mm rectangular form were laid one on the other and bent to a U shape using a press apparatus. The outer surface of the bent iron sheet and the inner surface of the bent copper sheet were each masked with a readily releasable resin-made masking tape for avoiding adhesion sticking thereto. Then, an adhesive resin layer was formed on the other surface of each sheet by electrodeposition coating with the adhesive composition obtained, whereby an iron sheet and a copper sheet respectively having an adhesive resin layer were obtained.

The thus-obtained adhesive resin layer-carrying iron and copper sheets were dried in a drying oven with hot air circulation at 90°C for 10 minutes. The thus-dried adhesive resin layers were not tacky at room temperature and became tacky at a temperature above 60°C. In that dried state, the dried adhesive resin layer had a thickness of 15 to 20 µm.

The masking tape was peeled off from each of the dried iron and copper sheets, the U-shaped copper sheet was inserted into the U-shaped iron sheet so that both the dried adhesive layer surfaces came into contact with each other. While maintaining the U shape, both the metal sheets were stuck together using a vacuum press apparatus set at 190°C for lamination and adhering of the iron sheet and copper sheet to each other. The assembly was then heated at 190°C for 25 minutes for curing the adhesive resin layer, whereby a laminate (laminate 4) was obtained. The vacuum press conditions were as follows: 0.5 MPa, 3 seconds.

### Comparative Examples 1 and 2

Laminates 5 and 6 were obtained in the same manner as in Examples 1 and 2, respectively, except that Powertop U-30 (blocked isocyanate curing type epoxy resin-based cationic electrodeposition adhesive, product of Nippon Paint Co.) was used in lieu of the adhesive composition obtained in the adhesive composition production.

### Comparative Example 3

Alteco 3500 (ordinary temperature curing type epoxy resin adhesive, product of Alpha Giken) was applied to one side of each of the same copper sheets as used in Example 3 to a film thickness of 15 to 20 µm using a bar coater. Then, the sheets were placed one on another in a manner such that the adhesion surface area amounted to 12 mm square. The two copper sheets were pressed to each other using a vacuum press apparatus set at 190°C to accomplish lamination/adhesion and curing simultaneously to give a laminate (laminate 7). The vacuum press conditions were as follows: 0.5 MPa, 25 minutes.

### [Evaluation]

The laminates 1, 2, 5 and 6 obtained in Examples 1 and 2 and Comparative Examples 1 and 2 were measured for peel adhesion strength upon peeling at 90°, and the laminates 3 and 7 obtained in Examples 3 and Comparative Examples 3 for tensile shear adhesion strength, using a Shimadzu model AGS-100 autograph. A peel adhesion strength upon peeling at 90° of 1 MPa or above was regarded as satisfactory, and a tensile adhesion strength of 20 MPa or above as satisfactory. The measurement conditions were as follows: pulling speed 5 mm/minute, 20°C.

The laminates of Examples 1, 3 and 5 and Comparative Examples 1 and 3 were also measured for dielectric breakdown resistance. A value of 1.0 kV or above was regarded as satisfactory. The method of dielectric breakdown resistance measurement was as shown below.

### (Method of dielectric breakdown voltage measurement)

### Measuring apparatus: Withstanding voltage insulation tester model 8525 (product of Tsuruga Electric Corp.)

### Measurement conditions: 500 V/sec.

Measuring terminals of the above apparatus were connected with a part of the conductive material and a part of the functional material, respectively, and voltage application was made under the above conditions.

**Table 1**

| | Example | | | | Comparative Example | | |
|---|---|---|---|---|---|---|---|
| | 1 | 2 | 3 | 5 | 1 | 2 | 3 |
| Peel adhesion strength upon peeling at 90° (kN/m) | 12 | 1. 5 | - | - | 0.7 | 0.4 | - |
| Tensile shear adhesion strength (MPa) | - | - | 33 | - | - | - | 13 |
| Dielectric breakdown voltage (kV) | 4.7 | - | 4.7 | 4.5 | 0.7 | - | 1.1 |

As is apparent from Table 1, the laminates obtained in Examples 1 to 3 and 5 were higher in adhesion strength than and superior in dielectric breakdown voltage to those obtained in Comparative Examples 1 to 3.

## Claims

1. A method of adhesion of conductive materials comprising the step (1) of forming an adhesive surface having an adhesive resin layer on a conductive material by an electrodeposition step with an adhesive composition and the step (2) of joining an adherend surface of an adhesion target to the adhesive surface having the adhesive resin layer obtained in the step (1),
wherein the adhesive composition comprises a hydratable functional group- and unsaturated bond-containing cationic resin composition.

2. The method of adhesion of conductive materials according to Claim 1,
wherein the adhesive composition is substantially incapable of generating any volatile matter in the step of heating for curing.

3. The method of adhesion of conductive materials according to Claim 1 or 2,
wherein the cationic resin composition is one allowing the formation, in the adhesive resin layer, of such chemical species activated by the electrode reaction caused by voltage application in the electrodeposition step as can promote the progress of the curing reaction.

4. The method of adhesion of conductive materials according to any of Claim 1 to 3,
wherein the hydratable functional group is a sulfonium group.

5. The method of adhesion of conductive materials according to any of Claim 1 to 4,
wherein the unsaturated bond is at least partly a propargyl carbon-carbon triple bond.

6. The method of adhesion of conductive materials according to any of Claim 1 to 5,
wherein the cationic resin composition has a sulfonium group content of 5 to 400 millimoles, a propargyl group content of 10 to 495 millimoles, and a total content of sulfonium and propargyl groups of not more than 500 millimoles, per 100 g of the solid matter in the cationic resin composition.

7. The method of adhesion of conductive materials according to any of Claim 1 to 6,
wherein the cationic resin composition has a sulfonium group content of 5 to 250 millimoles, a propargyl group content of 20 to 395 millimoles, and a total content of sulfonium and propargyl groups of not more than 400 millimoles, per 100 g of the solid matter in the cationic resin composition.

8. The method of adhesion of conductive materials according to any of Claim 1 to 7,
wherein the cationic resin composition has an epoxy resin as a skeleton.

9. The method of adhesion of conductive materials according to Claim 8,
wherein the epoxy resin is a novolak cresol epoxy resin or novolak phenol epoxy resin and has a number average molecular weight of 700 to 5,000.

10. The method of adhesion of conductive materials according to any of Claim 1 to 9,
which comprises a drying step between the step (1) and step (2).

11. The method of adhesion of conductive materials according to any of Claim 1 to 10,
wherein the step (2) comprises a step of adhesion with heating and a step of curing by heating.

12. The method of adhesion of conductive materials according to any of Claim 1 to 11,
wherein the adherend surface is an adhesive surface having an adhesive resin layer.

13. The method of adhesion of conductive materials according to any of Claim 1 to 12,
wherein the adhesion target is a conductive material and the adherend surface is an adhesive surface having an adhesive resin layer formed by an electrodeposition step of a conductive material with an adhesive composition.

14. The method of adhesion of conductive materials according to any of Claim 1 to 13,
wherein the conductive material is made of copper, aluminum, iron, or an alloy mainly composed of these.

15. A laminate as obtained by the method of adhesion of conductive materials according to any of Claim 1 to 14.

16. An adhesive composition capable of forming an adhesive resin layer by an electrodeposition step,
wherein the adhesive composition comprises a hydratable functional group- and unsaturated bond-containing cationic resin composition.

## Patentansprüche

1. Verfahren zum Verkleben von leitfähigen Materialien, umfassend den Schritt (1) des Bildens einer haftenden Oberfläche mit einer haftenden Harzschicht auf einem leitfähigen Material durch einen Elektro- bzw. elektrochemischen Abscheidungsschritt mit einer Klebezusammensetzung und den Schritt (2) des Verbindens einer zu verklebenden Oberfläche eines Verhaftungsziels an der haftenden Oberfläche mit der im Schritt (1) erhaltenen haftenden Harzschicht,
wobei die Klebezusammensetzung eine hydratisierbare funktionelle Gruppen und ungesättigte Bindung enthaltende kationische Harzzusammensetzung umfasst.

2. Verfahren zum Verkleben von leitfähigen Materialien gemäß Anspruch 1,
wobei die Klebezusammensetzung im Wesentlichen nicht zur Erzeugung jeglicher flüchtiger Substanz in dem Erwärmungsschritt für das Härten imstande ist.

3. Verfahren zum Verkleben von leitfähigen Materialien gemäß Anspruch 1 oder 2,
wobei die kationische Harzzusammensetzung eine solche ist, welche die Bildung in der haftenden Harzschicht von solcher chemischer Spezies erlaubt, die durch die durch die Anlegung einer Spannung in dem Elektro-Abscheidungsschritt bewirkte Elektrodenreaktion aktiviert wird, wie sie den Fortschritt der Härtungsreaktion fördern kann.

4. Verfahren zum Verkleben von leitfähigen Materialien gemäß mindestens einem der Ansprüche 1 bis 3,
wobei die hydratisierbare funktionelle Gruppe eine Sulfoniumgruppe ist.

5. Verfahren zum Verkleben von leitfähigen Materialien gemäß mindestens einem der Ansprüche 1 bis 4,
wobei die ungesättigte Bindung zumindest teilweise eine Propargyl-Kohlenstoff-Kohlenstoff-Dreifachbindung ist.

6. Verfahren zum Verkleben von leitfähigen Materialien gemäß mindestens einem der Ansprüche 1 bis 5,
wobei die kationische Harzzusammensetzung einen Sulfoniumgruppengehalt von 5 bis 400 Millimol, einen Propargylgruppengehalt von 10 bis 495 Millimol und einen Gesamtgehalt an Sulfonium- und Propargylgruppen von nicht mehr al 500 Millimol pro 100 g der Feststoffsubstanz in der kationischen Harzzusammensetzung aufweist.

7. Verfahren zum Verkleben von leitfähigen Materialien gemäß mindestens einem der Ansprüche 1 bis 6,
wobei die kationische Harzzusammensetzung einen Sulfoniumgruppengehalt von 5 bis 250 Millimol, einen Propargylgruppengehalt von 20 bis 395 Millimol und einen Gesamtgehalt an Sulfonium- und Propargylgruppen von nicht mehr als 400 Millimol pro 100 g der Feststoffsubstanz in der kationischen Harzzusammensetzung aufweist.

8. Verfahren zum Verkleben von leitfähigen Materialien gemäß mindestens einem der Ansprüche 1 bis 7,
wobei die kationische Harzzusammensetzung ein Epoxyharz als ein Skelett aufweist.

9. Verfahren zum Verkleben von leitfähigen Materialien nach Anspruch 8,
wobei das Epoxyharz ein Novolak-Cresol-Epoxyharz oder Novolak-Phenol-Epoxyharz ist und ein zahlenmittleres Molekulargewicht von 700 bis 5000 besitzt.

10. Verfahren zum Verkleben von leitfähigen Materialien gemäß mindestens einem der Ansprüche 1 bis 9,
umfassend einen Trocknungsschritt zwischen dem Schritt (1) und Schritt (2).

11. Verfahren zum Verkleben von leitfähigen Materialien gemäß mindestens einem der Ansprüche 1 bis 10,
wobei der Schritt (2) einen Verklebungsschritt unter Erwärmen und einen Härtungsschritt durch Erwärmen umfasst.

12. Verfahren zum Verkleben von leitfähigen Materialien gemäß mindestens einem der Ansprüche 1 bis 11,
wobei die zu verklebende Oberfläche eine haftende Oberfläche mit einer haftenden Harzschicht ist.

13. Verfahren zum Verkleben von leitfähigen Materialien gemäß mindestens einem der Ansprüche 1 bis 12,
wobei das Verhaftungsziel ein leitendes Material ist und die zu verklebende Oberfläche eine haftende Oberfläche mit einer haftenden Harzschicht ist, die durch einen Elektro-Abscheidungsschritt eines leitfähigen Materials mit einer Klebezusammensetzung gebildet wird.

14. Verfahren zum Verkleben von leitfähigen Materialien gemäß mindestens einem der Ansprüche 1 bis 13,
wobei das leitende Material aus Kupfer, Aluminium, Eisen oder einer hauptsächlich aus diesen bestehende Legierung gebildet ist.

15. Laminat, wie es durch das Verfahren zum Verkleben von leitfähigen Materialien gemäß mindestens einem der Ansprüche 1 bis 14 erhalten wird.

16. Klebezusammensetzung, die zur Bildung einer haftenden Harzschicht durch einen Elektro-Abscheidungsschritt imstande ist,
wobei die Klebezusammensetzung eine hydratisierbare funktionelle Gruppen und ungesättigte Bindung enthaltende kationische Harzzusammensetzung umfasst.

## Revendications

1. Procédé d'adhésion de matériaux conducteurs comprenant l'étape (1) consistant à former une surface adhésive ayant une couche de résine adhésive sur un matériau conducteur par une étape de dépôt électrolytique avec une composition adhésive, et l'étape (2) consistant à assembler une surface d'adhésion d'une cible d'adhésion et la surface adhésive ayant la couche de résine adhésive obtenue dans l'étape (1),
dans lequel la composition adhésive comprend une composition de résine cationique contenant un groupe fonctionnel hydratable et une liaison insaturée.

2. Procédé d'adhésion de matériaux conducteurs selon la revendication 1,
dans lequel la composition adhésive est sensiblement incapable de produire une matière volatile quelconque dans l'étape de chauffage pour le durcissement.

3. Procédé d'adhésion de matériaux conducteurs selon la revendication 1 ou 2,
dans lequel la composition de résine cationique est une composition permettant la formation, dans la couche de résine adhésive, d'espèces chimiques activées par la réaction à l'électrode provoquée par l'application d'une tension dans l'étape de dépôt électrolytique, qui peuvent favoriser la progression de la réaction de durcissement.

4. Procédé d'adhésion de matériaux conducteurs selon l'une quelconque des revendications 1 à 3,
dans lequel le groupe fonctionnel hydratable est un groupe sulfonium.

5. Procédé d'adhésion de matériaux conducteurs selon l'une quelconque des revendications 1 à 4,
dans lequel la liaison insaturée est au moins partiellement une triple liaison carbone - carbone d'un propargyle.

6. Procédé d'adhésion de matériaux conducteurs selon l'une quelconque des revendications 1 à 5,
dans lequel la composition de résine cationique a une teneur en groupe sulfonium de 5 à 400 millimoles, une teneur en groupe propargyle de 10 à 495 millimoles, et une teneur totale des groupes sulfonium et propargyle pas supérieure à 500 millimoles, pour 100 g de la matière solide dans la composition de résine cationique.

7. Procédé d'adhésion de matériaux conducteurs selon l'une quelconque des revendications 1 à 6,
dans lequel la composition de résine cationique a une teneur en groupe sulfonium de 5 à 250 millimoles, une teneur en groupe propargyle de 20 à 395 millimoles, et une teneur totale des groupes sulfonium et propargyle pas supérieure à 400 millimoles, pour 100 g de la matière solide dans la composition de résine cationique.

8. Procédé d'adhésion de matériaux conducteurs selon l'une quelconque des revendications 1 à 7,
dans lequel la composition de résine cationique a une résine époxy en tant que squelette.

9. Procédé d'adhésion de matériaux conducteurs selon la revendication 8,
dans lequel la résine époxy est une résine époxy crésolique novolaque ou une résine époxy phénolique novolaque et a un poids moléculaire moyen en nombre de 700 à 5 000.

10. Procédé d'adhésion de matériaux conducteurs selon l'une quelconque des revendications 1 à 9,
qui comprend une étape de séchage entre l'étape (1) et l'étape (2).

11. Procédé d'adhésion de matériaux conducteurs selon l'une quelconque des revendications 1 à 10,
dans lequel l'étape (2) comprend une étape d'adhésion avec chauffage et une étape de durcissement par chauffage.

12. Procédé d'adhésion de matériaux conducteurs selon l'une quelconque des revendications 1 à 11,
dans lequel la surface d'adhésion est une surface adhésive ayant une couche de résine adhésive.

13. Procédé d'adhésion de matériaux conducteurs selon l'une quelconque des revendications 1 à 12,
dans lequel la cible d'adhésion est un matériau conducteur et la surface d'adhésion est une surface adhésive ayant une couche de résine adhésive formée par une étape de dépôt électrolytique d'un matériau conducteur avec une composition adhésive.

14. Procédé d'adhésion de matériaux conducteurs selon l'une quelconque des revendications 1 à 13,
dans lequel le matériau conducteur est en cuivre, en aluminium, en fer, ou un alliage principalement composé de ceux-ci.

15. Stratifié tel qu'obtenu par le procédé d'adhésion de matériaux conducteurs selon l'une quelconque des revendications 1 à 14.

16. Composition adhésive capable de former une couche de résine adhésive par une étape de dépôt électrolytique,
dans laquelle la composition adhésive comprend une composition de résine cationique contenant un groupe fonctionnel hydratable et une liaison insaturée.
